# EUROPÄISCHE PATENTSCHRIFT

(11) **EP 1 228 678 B1**
(45) Veröffentlichungstag und Bekanntmachung des Hinweises auf die Patenterteilung: **28.06.2006**
(21) Anmeldenummer: 00987083.3
(22) Anmeldetag: 06.11.2000
(51) Int. Cl.: H05K 13/04

(54) **VAKUUMPIPETTE ZUM ANSAUGEN VON ELEKTRISCHEN BAUELEMENTEN**
VACUUM PIPETTE FOR GRIPPING ELECTRICAL COMPONENTS BY SUCTION
PIPETTE SOUS VIDE POUR ASPIRER DES COMPOSANTS ELECTRONIQUES

(30) Priorität: 09.11.1999 DE 19953881
(43) Veröffentlichungstag der Anmeldung: 07.08.2002
(73) Patentinhaber: Siemens AG, 80333 München (DE)
(72) Erfinder: REIMANN, Günter, 81375 München (DE)
(86) Internationale Anmeldenummer: PCT/DE2000/003883
(87) Internationale Veröffentlichungsnummer: WO 2001/035710

(56) Entgegenhaltungen:
- WO-A-98/33369

## Beschreibung

Die Erfindung bezieht sich auf eine Vakuumpipette zum Ansaugen von elektrischen Bauelementen, wobei die Vakuumpipette auf einen Schaft eines Bestückkopfes eines Bestückautomaten aufsteckbar ist,
wobei das zu greifende Bauelement an eine vom Schaft abgewandte Stirnseite der Vakuumpipette ansaugbar ist.

Eine derartige Vakuumpipette ist zum Beispiel durch die WO 98/33369 A bekannt geworden. Danach weist die Vakuumpipette einen zentralen Vakuumkanal auf, der in einer stirnseitigen Saugöffnung mündet, die mit einem Filtergitter versehen ist. Dieses soll verhindern, daß kleine Bauelemente in den Saugkanal eingesaugt werden können. Die entsprechend engen Durchlaßöffnungen des Filtergitters verringern den Saugquerschnitt so stark, daß die Saugkraft nicht mehr ausreicht, um größere Bauelemente sicher zu halten.

Die Bauelemente werden zum Beispiel in Gurten in engem Abstand bereitgestellt. Insbesondere bei kleinen Bauelementen besteht die Gefahr, daß beim Abholen Bauelemente aus benachbarten Taschen angesaugt werden. Um diese Gefahr auszuschalten, muß das Sauggitter entsprechend schmal gehalten werden. Um den Querschnitt durch die Gitterstege nicht zu stark zu verringern, muß der Teilungsabstand zwischen den Gitterstegen möglichst groß gehalten werden. Dadurch besteht die Gefahr, daß Bauelemente von sehr kleinem Querschnitt in eine der Durchlaßöffnungen abkippen und hochkant hindurchgesaugt werden. Da der Querschnitt des Saugkanals relativ groß ist, kann das Bauelement ungehindert in das Steuerungs- und Erzeugersystem für das Vakuum hineingezogen werden und dort Funktionsstörungen insbesondere durch Anhäufungen verursachen.

Die Miniaturisierung der Bauelemente geht derzeit bis zu Abmessungen von 0,25 x 0,25 x 0,5 mm. Entsprechend feine Durchlaßöffnungen sind spritzgußtechnisch nicht mehr realisierbar, so daß hier die Gefahr des Einsaugens besonders groß ist. Eine fehlerhafte Vakuumabfrage kann dazu führen, daß die Vakuumpipette ohne Bauelement mit Lotpaste der Leiterplatte kontaminiert wird, wodurch sich der Saugquerschnitt des Filtergitters verringert und eine Vakuumabfrage zu Auswertefehlern führt.Durch die unterschiedlichen Saugquerschnitte der Filtergitter unterschiedlicher Pipettentypen ergeben sich sehr unterschiedliche Vakuumschwellwerte zur Detektion des Vorhandenseins eines Bauelementes, wodurch die Abfragesicherheit entsprechend beeinträchtigt ist.

Ferner ist durch die JP 10-242694 A ein Bestückkopf mit einem Schaft bekannt geworden, an dessen freiem Ende ein Halter für die Vakuumpipette angebracht ist. Der Saugkanal der Vakuumpipette ist durchgehend vollflächig ausgebildet. Auf das Schaftende ist ferner ein Filterbauteil für die Saugluft aufgesteckt, das eingesaugte Partikel daran hindert, in das Innere des Bestückkopfes zu gelangen. Wegen des labyrintartigen Strömungsverlaufs können sich eingesaugte Partikel zwischen dem Schaft und der Pinole anhäufen und bei längerem Gebrauch der Vakuumpipette den Strömungsquerschnitt so stark verengen, daß die Vakuumabfrage gestört wird. Das Filterbauteil selbst ist Bestandteil des Halters und muß ab einem bestimmten Verstopfungsgrad ausgetauscht werden.

In ähnlicher Weise ist nach der JP 2-170600 A auf einen rohrartigen Halter eines Bestückkopfes ein Filterzylinder mit einem erweiterten Filtergitter aufgesetzt, wobei die austauschbare Vakuumpipette auf das freie Ende des Filterzylinders aufsteckbar ist. Der Filterzylinder stellt in der Verlängerung des Halters ein separates Zwischenglied dar, das einen zusätzlichen Montageschritt mit einer zusätzlichen Koppelstelle erfordert, die Einbaugenauigkeit der Vakuumpipette verringert und die Bauhöhe vergrößert. Der vergrößerte Abstand zwischen der Pipettenspitze und dem Halter verringert außerdem die Steifigkeit des Systems was unter dem Einfluß der hohen Beschleunigungen der Positionierbewegungen zu einer Verringerung der Postioniergenauigkeit führt.

Der Erfindung liegt die Aufgabe zugrunde, die Funktionssicherheit des Bestückkopfes zu erhöhen.

Diese Aufgabe wird durch die Erfindung gemäß Anspruch 1 gelöst. Durch die Anordnung des Filters in den einzelnen Vakuumpipetten ist es möglich, den Filterbereich an die an die Größe der angesaugten Bauelemente weitgehend anzupassen. Ferner kann der Filter in einem Bereich nahe der Ansaugöffnung ausgebildet werden. Beim Aufsetzen der Bauelemente auf eine Leiterplatte wird üblicherweise auf den Saugkanal ein Druckluftimpuls geschaltet. Diese Einrichtung kann dazu genutzt werden, angesammelte Partikel periodisch auszublasen.

Die enge Zuordnung des Filters zur Vakuumpipette ermöglicht es den Filter in dieser zu einstückig integrieren und somit mittels entsprechender Formwerkzeuge mit sehr geringem Mehraufwand kostengünstig auszubilden. Die Pipetten sind üblicherweise Verschleißteile, die periodisch vollautomatisch gewechselt werden. Dabei werden die angesammelten Störpartikel ohne jeden Zusatzaufwand mit entfernt, was auch bei einer vorzeitigen Verstopfung möglich ist.

Durch die Verlagerung des Filtergitters in das Innere der Vakuumpipette ist es möglich, die Saugöffnung an der Stirnfläche vollflächig auszubilden, wodurch der Saugquerschnitt entsprechend vergrößert wird. Das Filtergitter ist in einem Bereich angeordnet, in dem für das Filtergitter ein größerer Querschnitt zur Verfügung steht, so daß der gesamte Gitterquerschnitt erheblich größer ausgebildet werden kann. Die Anzahl und der Saugquerschnitt der einzelnen Durchlaßöffnungen kann entsprechend vergrößert werden, wodurch der gesamte Saugquerschnitt in diesem Bereich vergrößert wird. Dennoch können die Durchlaßöffnungen so schmal gehalten werden, daß auch die kleinsten Bauelemente sicher zurückgehalten werden. Diese gelangen nun nicht mehr in das Innere des Bestückkopfes. Auch bei eingesaugtem Bauelement bleibt genügend Restquerschnitt, um die Funktion der Vakuumabfrage zu gewährleisten. Das eingesaugte Bauelement kann über einen Fangbehälter verfahren werden und mittels eines Blasluftimpulses aus dem Saugkanal ausgestoßen werden.

Durch das erfindungsgemäß ausgestaltete Filtergitter nach Anspruch 2 ergibt sich in der Achsrichtung erstreckende Spalte, durch die die Saugluft in radialer Richtung hindurchströmt. Diese Spalte können sehr schmal und lang ausgebildet werden und ermöglichen einen gesamten Saugquerschnitt, der erheblich größer ist als bei einem Sauggitter in der Saugöffnung. Damit kann an dieser der volle Saugdruck aufgebaut werden.

Vorteilhafte Weiterbildungen der Erfindung sind in den Ansprüchen 2 bis 4 gekennzeichnet:

Durch die Weiterbildung nach Anspruch 2 ist sichergestellt, daß auch kleinste Bauelemente nicht in das Innere des Schafts hineingesaugt werden können.

Durch die Weiterbildung nach Anspruch 3 kann der Öffnungsquerschnitt des Filtergitters so groß gehalten werden, daß er die Vakuumabfrage nicht beeinträchtigt.

Durch die Weiterbildung nach Anspruch 4 wird das Sauggitter auch auf den Boden ausgedehnt, wobei die Weite der Durchlaßöffnung an die Weite der Spalte angepaßt werden kann.

Im folgenden wird die Erfindung anhand eines in der Zeichnung dargestellten Ausführungsbeispieles näher erläutert.
- Figur 1: zeigt einen Längsschnitt durch eine Vakuumpipette mit einem Schaft eines Bestückkopfes und einem elektrischen Bauelement,
- Figur 2: eine Seitenansicht eines Teiles der Vakuumpipette nach Anspruch 1,
- Figur 3: einen Schnitt entlang der Linie III-III in Figur 1,
- Figur 4: einen Teilschnitt entlang der Linie IV-IV in Figur 1.

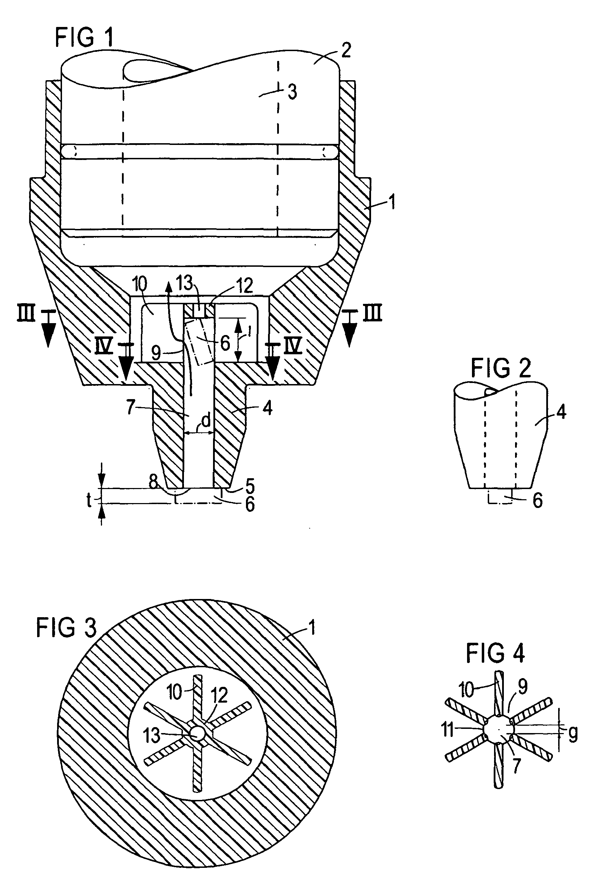

Nach Figur 1 ist eine Vakuumpipette 1 auf das Ende eines zylindrischen Schaftes 2 eines nicht näher dargestellten Bestückkopfes aufgesteckt. Der Schaft 2 weist eine Vakuumleitung 3 auf, die mittels pneumatischen Aggregaten und Ventilen steuerbar mit Vakuum, Atmosphäre oder Druckluft beaufschlagbar ist. Die spritzgußtechnisch hergestellte Vakuumpipette 1 weist eine zum Schaft koaxiale Saugspitze 4 auf, deren dem Schaft 2 abgewandte Stirnseite 5 als Anlagefläche für anzusaugende Bauelemente 7 dient. Die Saugspitze 4 weist einen zentralen Saugkanal 7 auf, der in einer stirnseitigen Saugöffnung 8 für die anzusaugenden Bauelemente 6 mündet. Die Länge des angesaugten Bauelementes 6 ist größer als der Durchmesser der Saugöffnung 8, so daß es sich an beiden Enden an der Stirnseite 5 abstützt.

In Figur 2 ist die Stirnseite des Bauelements 6 dargestellt. Hieraus ist ersichtlich, daß die Breite, die Dicke und auch die Diagonale des quaderförmigen Bauelementes 6 kleiner sind als der Durchmesser d des Saugkanals 7, der mit der Saugleitung 3 des Schafts in Wirkverbindung steht. Das Bauelement 6 kann bei azentrischer Anlage in die Saugöffnung 8 abkippen und in den Saugkanal 7 hineingesaugt werden.

Nach den Figuren 1, 3 und 4 erweitert sich die Vakuumpipette im Anschluß an die schmale Saugspitze stufenartig auf einen Durchmesser erweitert, der einen erheblichen größeren Bauraum umschließt. In diesem Bereich ist ein Filtergitter 9 angeordnet, durch das die Saugluft gemäß dem dargestellten s-förmigen Pfeil hindurchströmen kann. Das Filtergitter 9 besteht aus um den verlängerte Saugkanal herum radial abstehenden, sich in der Achsrichtung des Saugkanals erstreckenden flügelartigen Lamellen 10, die in gleicher Teilung umlaufend angeordnet sind. Die Lamellen 10 bilden entlang ihrer einander zugewandten Innenseiten schmale Spalte 11 von der Breite g und der Länge 1. Die Gesamtfläche der durch die Spalte gebildeten Durchlaßöffnungen des Filtergitters 9 ist erheblich größer als der Querschnitt der Saugöffnung 8. Die Breite g ist kleiner als die Dicke t des Bauelements 6, so daß ein eingesaugtes Bauelement 6 sicher zurückgehalten wird. Die Lamellen sind auf ihren Außenseiten zur Saugleitung 3 hin offen und mit dieser pneumatisch verbunden. Der Saugkanal 7 ist an dem Schaft 2 zugewandten inneren Ende der Lamellen 10 mit einem Boden 12 verschlossen, der seinerseits mit engen Durchlaßöffnungen 13 für die Saugluft versehen sein kann.

## Patentansprüche

1. Vakuumpipette (1) zum Ansaugen von elektrischen Bauelementen (6), wobei die Vakuumpipette auf einen Schaft (2) eines Bestückkopfes eines Bestückautomaten austauschbar aufsteckbar ist,
wobei das zu greifende Bauelement (6) an eine vom Schaft (2) abgewandte Stirnseite (5) der Vakuumpipette ansaugbar ist,
wobei ein Saugkanal (7) in einer stirnseitigen Saugöffnung (8) der Vakuumpipette (1) mündet und an eine Vakuumleitung (3) des Schafts (2) anschließbar ist,
wobei in die Vakuumpipette (1) im Bereich des Saugkanals (7) ein Filtergitter (9) mit Durchlaßöffnungen (13, 11) für die durch das Vakuum erzeugte Saugluft eingeformt ist, wobei
die Saugöffnung (8) vollflächig offen ausgebildet ist, wobei
das Filtergitter (9) mit Abstand zur Stirnseite (5) in einen erweiterten Innenraum der Vakuumpipette (1) verlagert ist und wobei
das Filtergitter (9) im Querschnitt größer ist als die Saugöffnung (8),
**dadurch gekennzeichnet, daß** das Filtergitter (9) aus einer Mehrzahl von um den Saugkanal (7) umlaufend verteilten flügelartigen Lamellen (10) gebildet ist, die sich in der Axialrichtung des Saugkanals (7) erstrecken und von diesem radial abstehen und
daß der Saugkanal (7) am inneren Ende der Lamellen (10) durch einen Boden (12) verschlossen ist.

2. Vakuumpipette nach Anspruch 1,
**dadurch gekennzeichnet, daß** die Durchlaßöffnungen durch zwischen den Lamellen ausgebildete Spalte (11) gebildet sind, deren Weite (g) schmaler ist als die kleinste Dicke (t) des zu greifenden kleinsten Bauelementes (6) .

3. Vakuumpipette nach Anspruch 1 oder 2,
**dadurch gekennzeichnet, daß** die Länge der Spalte (11) so groß ist, daß der gesamte Öffnungsquerschnitt des Filtergitters (9) größer ist als der stirnseitige Querschnitt der Saugöffnung (8).

4. Vakuumpipette nach Anspruch 1, 2 oder 3,
**dadurch gekennzeichnet, daß** der Boden (12) mit zumindest einer weiteren Durchlaßöffnung (13) von verringertem Querschnitt versehen ist.

## Claims

1. Vacuum pipette (1) for gripping electrical components (6) by suction, the vacuum pipette being able to be mounted in an exchangeable manner onto a shaft (2) of a placement head of an automatic placement machine,
the component (6) to be gripped being able to be gripped by suction onto an end side (5) of the vacuum pipette, said end side being remote from the shaft (2),
a suction channel (7) merging with an end-side suction opening (8) of the vacuum pipette (1) and being able to be connected to a vacuum line (3) of the shaft (2),
a filter grid (9) with passage openings (13, 11) for the suction air generated by the vacuum being incorporated into the vacuum pipette (1) in the region of the suction channel (7),
the suction opening (8) being formed such that it is open over its whole area,
the filter grid (9), at a distance from the end side (5), being displaced into an extended interior space of the vacuum pipette (1), and
the cross section of the filter grid (9) being greater than that of the suction opening (8), **characterized in that** the filter grid (9) is formed from a plurality of wing-like lamellae (10) which are distributed peripherally around the suction channel (7), extend in the axial direction of the suction channel (7) and project radially from the latter, and
**in that** the suction channel (7) is closed by a bottom (12) at the inner end of the lamellae (10).

2. Vacuum pipette according to Claim 1,
**characterized in that** the passage openings are formed by gaps (11) which are formed between the lamellae and whose width (g) is narrower than the smallest thickness (t) of the smallest component (6) to be gripped.

3. Vacuum pipette according to claim 1 or 2,
**characterized in that** the length of the gaps (11) is so large that the entire opening cross section of the filter grid (9) is greater than the end-side cross section of the suction opening (8).

4. Vacuum pipette according to Claim 1, 2 or 3,
**characterized in that** the bottom (12) is provided with at least one further passage opening (13) of reduced cross section.

## Revendications

1. Pipette sous vide (1) pour aspirer des composants électriques (6), la pipette sous vide, pouvant être fixée de manière remplaçable sur une tige (2) d'une tête d'insertion d'une machine d'insertion automatique,
le composant (6) à saisir pouvant être aspiré sur un côté frontal (5) de la pipette sous vide éloigné de la tige (2),
un canal d'aspiration (7) débouchant dans une ouverture d'aspiration (8) de la pipette sous vide (1) située sur le côté frontal et pouvant être connecté à une conduite de vide (3) de la tige (2),
une grille de filtrage (9) pourvue d'ouvertures de passage (13, 11) pour l'air aspiré produit par le vide étant formée dans la pipette sous vide (1) dans la zone du canal d'aspiration (7),
l'ouverture d'aspiration (8) étant exécutée de manière ouverte sur toute la surface,
la grille de filtrage (9) étant déplacée dans un espace intérieur élargi de la pipette sous vide (1), à une distance du côté frontal (5), et
la grille de filtrage (9) ayant une plus grande section transversale que l'ouverture d'aspiration (8),
**caractérisée en ce que** la grille de filtrage (9) est formée d'une pluralité de lamelles (10) similaires à des ailes réparties sur la circonférence du canal d'aspiration (7) qui s'étendent dans la direction axiale du canal d'aspiration (7) et s'éloignent radialement de celui-ci et **en ce que** le canal d'aspiration (7) est fermé par un fond (12) au niveau de l'extrémité intérieure des lamelles (10) .

2. Pipette sous vide selon la revendication 1, **caractérisée en ce que** les ouvertures de passage sont formées par des fentes (11) exécutées entre les lamelles dont la largeur (g) est inférieure à l'épaisseur minimale (t) du plus petit composant (6) à saisir.

3. Pipette sous vide selon la revendication 1 ou 2, **caractérisée en ce que** la fente (11) est suffisamment longue pour que la section transversale d'ouverture totale de la grille de filtrage (9) soit supérieure à la section transversale de l'ouverture d'aspiration (8) sur le côté frontal.

4. Pipette sous vide selon la revendication 1, 2 ou 3, **caractérisée en ce que** le fond (12) est pourvu d'au moins une ouverture de passage (13) supplémentaire de section transversale réduite.
